# EUROPEAN PATENT SPECIFICATION

(11) **EP 4 163 709 B1**
(45) Date of publication and mention of the grant of the patent: **05.11.2025**
(21) Application number: 22180006.3
(22) Date of filing: 20.06.2022
(51) Int. Cl.: G02F 1/1333, H10K 59/80

(54) **DISPLAY DEVICE**
ANZEIGEVORRICHTUNG
DISPOSITIF D'AFFICHAGE

(30) Priority: 05.10.2021 KR 20210131539
(43) Date of publication of application: 12.04.2023
(73) Proprietor: LG Display Co., Ltd., SEOUL, 07336 (KR)
(72) Inventor: PARK, Chanhyeok, 10845 Paju-si (KR)
(74) Representative: Bryn-Jacobsen, Caelia

(56) References cited:
- EP-A1- 4 020 074
- CN-U- 205 303 466
- US-A1- 2020 211 920
- US-B2- 10 852 768

## Description

### BACKGROUND

### Field

The present disclosure relates to a display device and more specifically, to a display device that can improve heat-dissipation and impact-absorbing functions and improve a display quality while simplifying a structure thereof.

### Description of Related Art

A display device that displays an image on a TV, a monitor, a smart phone, a tablet PC, a laptop computer, and the like is used in various manners and forms.

Following a liquid crystal display device (LCD) that has been used up to now among the display devices, use and application ranges of an organic light-emitting display device (OLED) are gradually expanding.

The display device includes a liquid crystal or a light-emitting element to realize the image, and includes a thin-film transistor for individually controlling an operation of each liquid crystal or light-emitting element, to display the image to be displayed on a substrate.

For example, the organic light-emitting display device includes a thin-film transistor for driving a pixel and a light-emitting element that generates light by receiving a signal from the thin-film transistor.

The display device includes a display area for forming the image and a non-display area in which additional components such as a circuit board, a driving integrated circuit, or the like are disposed.

A width of the non-display area can increase due to the additional component. Accordingly, a thickness and a width of the display device can increase.

The increase in the thickness and the width of the display device is disadvantageous in terms of portability or design.

In order to reduce the thickness and the width of the display device, the non-display area of the display panel can be bent to dispose a portion of the non-display area on a back surface of the display panel.

In the organic light-emitting display device having the bent area on the display panel, as a thickness of the display device increases, the bent area of the display panel increases, which increases the non-display area, and thus an overall size of the display panel increases.

High-temperature heat is generated from the additional components located in the non-display area and the display panel, and the display panel exposed to the high-temperature heat shortens a lifespan thereof, so that a structure to improve a heat-dissipation function is required.

Further, the display device can be easily damaged by an external impact due to a small thickness and a complex configuration thereof or external moisture can penetrate the display device, so that a structure to improve rigidity and a waterproof function is also being developed.

EP4020074A1 in an abstract states that "Disclosed are a display device (10) and a display apparatus (1) which can improve a heat-dissipation performance and a shock absorption function while reducing a bezel area. To this end, a cushion plate (300) includes a metal foam (320) that has both a heat-dissipation function and a cushion function, so that both of an effective heat-dissipation function and an effective cushion function can be realized only using the metal foam (320) without addition of a separate heat-dissipation layer or cushion layer. Further, the metal foam (320) of the cushion plate (300) has very excellent heat-dissipation function and cushioning function at only a small thickness thereof, so that a total thickness of the cushion plate (300) can be greatly reduced, and the bezel area can be reduced."

CN205303466U in an abstract states that "The utility model provides a flexible display base plate, display device belongs to and shows technical field, and it can solve present chip, and to bind the flexible display base plate fragile, and it is low to bind the precision, the unable high -resolution problem that realizes. The utility model discloses a flexible display base plate, including flexible substrate, thin film transistor layer on the first face of flexible substrate, the notacoria is supported at dihedral at least one deck of flexible substrate to formation, wherein, the hardness that supports the notacoria is greater than the hardness of flexible substrate, therefore, support the notacoria and support flexible substrate, make flexible substrate difficult curling, the roughness that keeps flexible surface of the substrate, thereby directly bind the chip on flexible substrate, can not damage flexible base plate, and it is littleer that the terminal size can be done, bind the precision height, can satisfy the high -resolution requirement completely. The utility model discloses a flexible display base plate is applicable to various display device, is particularly useful for the organic electroluminescence display."

US2020/211920A1 in an abstract state that "An adhesive film includes a porous metal layer having a plurality of pores therein, a first adhesive layer on one side of the porous metal layer, an adhesive substance at least partially filling the pores of the porous metal layer, and a plurality of first thermal conductive members distributed in the first adhesive layer."

### SUMMARY

The present invention is set out in the independent claims, with some optional features set out in the claims dependent thereto.

In a case of a display device, it is necessary to reduce or minimize a non-display area to secure a display area as large as possible compared to a total area of the display device. To this end, a display panel can place a pad disposed in the non-display area and various additional components such as a driving integrated circuit or a circuit board on a back surface thereof.

For example, the various additional components can be mounted on a connecting component such as a flexible circuit board and connected to the pad to be located on the back surface of the display panel. Because the pad, which is a distal end of the display panel, is bent in a backward direction, the various additional components can be located on the back surface of the display panel.

In this case, when a bending radius of curvature of the pad increases, the flexible circuit board or the display panel can be bent more stably and easily. However, as the bending radius of curvature increases, a bezel area can increase, and thus, an overall width of the display device can also increase.

A cushion plate for heat-dissipation and impact-absorption can be disposed on the back surface of the display panel. Because the pad is bent to surround a side surface of the cushion plate, the thicker the cushion plate, the greater the bending radius of curvature.

The cushion plate can be formed by combining a plurality of layers with various functions such as a heat-dissipation layer having a heat-dissipation function, a cushion layer that can absorb an impact, and as an adhesive layer that couples the heat-dissipation layer and the cushion layer to each other.

When thicknesses of the heat-dissipation layer and the cushion layer are as great as possible, the heat-dissipation function and the impact-absorbing function can be increased. However, as the thicknesses increase, the overall thickness of the display device increases, which can lead to the increase in the bezel area.

When the thicknesses of the heat-dissipation layer and the cushion layer are reduced in order to reduce the overall thickness of the display device, the heat-dissipation function and the impact-absorbing function can be reduced.

Further, when a surface-treatment is performed to improve the function of the cushion layer or the heat-dissipation layer, surface roughness of the cushion layer or the heat-dissipation layer increases, so that a surface of the cushion layer or the heat-dissipation layer can be visually recognized from the outside of the display panel. This is a factor that can degrade the display quality.

The present disclosure aims to improve the impact-absorbing and heat-dissipation functions while reducing the thickness and the width of the display device. Further, the present disclosure aims to improve the display quality by reducing the visual recognition of the surface of the cushion layer or the heat-dissipation layer from the outside of the display panel.

Purposes of the present disclosure are not limited to the above-mentioned purpose. Other purposes and advantages of the present disclosure that are not mentioned can be understood based on following descriptions, and can be more clearly understood based on examples of the present disclosure. Further, it will be easily understood that the purposes and advantages of the present disclosure can be realized using means shown in the claims and combinations thereof.

A display device according to an embodiment includes a display panel having a first portion including a pixel array for displaying an image and a second portion including a driving circuit for driving the pixel array. A third portion of the display panel is bent such that the second portion is disposed under the first portion. The display device also includes a cushion plate disposed between a back surface of the first portion of the display panel and a back surface of the second portion of the display panel. The cushion plate includes a porous substrate formed with a plurality of pores, and an adhesive member including an adhesive component on the porous substrate. The adhesive member may be closer to the display panel than the porous substrate. A surface roughness of an upper surface of the adhesive member is lower than a surface roughness of an upper surface of the porous substrate.

Other specific details of the example are included in the detailed description and the drawings.

The cushion plate according to the present disclosure includes the porous substrate that has both the heat-dissipation function and the cushion function, so that the cushion plate can have the heat-dissipation function and the cushion function with only the porous substrate without adding the separate heat-dissipation layer or cushion layer.

Because the porous substrate has the very good heat-dissipation function and cushion function even with the small thickness, it is possible to significantly reduce the overall thickness of the cushion plate, thereby reducing the overall thickness of the display device and the non-display area.

Further, the cushion plate of the present disclosure includes the adhesive member with the flat upper surface to prevent the surface of the porous substrate from being visually recognized from the outside of the display panel.

Effects of the present disclosure are not limited to the above-mentioned effects, and other effects as not mentioned will be clearly understood by those skilled in the art from following descriptions.

### BRIEF DESCRIPTION OF DRAWINGS

FIG. 1A and FIG. 1B show a front surface and a back surface of a display device according to an example of the present disclosure.
FIG. 2 is a cross-sectional view taken along a line I-I' in FIG. 1A.
FIG. 3A is an enlarged cross-sectional view of an area A in FIG. 2, which is a cross-sectional view showing an example of a cushion plate according to the present disclosure.
FIG. 3B is a product cross-sectional view of a cushion plate according to an example of the present disclosure.
FIG. 4A to FIG. 4B are cross-sectional views for other examples of a cushion plate according to the present disclosure. FIG. 4C shows a cross-sectional view of an example of a cushion plate that is not according to the claimed invention.
FIG. 5A and FIG. 5B are cross-sectional views for other examples of a cushion plate that are not according to the claimed invention.
FIG. 6A to FIG. 6E show an example for a method for manufacturing a cushion plate that is not according to the claimed invention.

### DETAILED DESCRIPTIONS

Advantages and features of the present disclosure will become apparent with reference to examples described later in detail together with the accompanying drawings. However, the present disclosure is not limited to the examples as disclosed below, but can be implemented in various different forms. Thus, these examples are set forth only to make the present disclosure complete, and to completely inform the scope of the disclosure to those of ordinary skill in the technical field to which the present disclosure belongs, and the present disclosure is only defined by the scope of the claims.

A shape, a size, a ratio, an angle, a number, etc. disclosed in the drawings for describing the examples of the present disclosure are exemplary, and the present disclosure is not limited thereto. The same reference numerals refer to the same elements herein. Further, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure can be practiced without these specific details. In other instances, well-known methods, procedures, components, and circuits have not been described in detail so as not to unnecessarily obscure aspects of the present disclosure.

The terminology used herein is directed to the purpose of describing particular examples only and is not intended to be limiting of the present disclosure. As used herein, the singular constitutes "a" and "an" are intended to include the plural constitutes as well, unless the context clearly indicates otherwise. It will be further understood that the terms "comprise", "including", "include", and "including" when used in this specification, specify the presence of the stated features, integers, operations, elements, and/or components, but do not preclude the presence or addition of one or more other features, integers, operations, elements, components, and/or portions thereof. As used herein, the term "and/or" includes any and all combinations of one or more of the associated listed items. Expression such as "at least one of" when preceding a list of elements can modify the entire list of elements and may not modify the individual elements of the list. In interpretation of numerical values, an error or tolerance therein can occur even when there is no explicit description thereof.

In addition, it will also be understood that when a first element or layer is referred to as being present "on" a second element or layer, the first element can be disposed directly on the second element or can be disposed indirectly on the second element with a third element or layer being disposed between the first and second elements or layers. It will be understood that when an element or layer is referred to as being "connected to", or "coupled to" another element or layer, it can be directly on, connected to, or coupled to the other element or layer, or one or more intervening elements or layers can be present. In addition, it will also be understood that when an element or layer is referred to as being "between" two elements or layers, it can be the only element or layer between the two elements or layers, or one or more intervening elements or layers can also be present.

Further, as used herein, when a layer, film, region, plate, or the like is disposed "on" or "on a top" of another layer, film, region, plate, or the like, the former can directly contact the latter or still another layer, film, region, plate, or the like can be disposed between the former and the latter. As used herein, when a layer, film, region, plate, or the like is directly disposed "on" or "on a top" of another layer, film, region, plate, or the like, the former directly contacts the latter and still another layer, film, region, plate, or the like is not disposed between the former and the latter. Further, as used herein, when a layer, film, region, plate, or the like is disposed "below" or "under" another layer, film, region, plate, or the like, the former can directly contact the latter or still another layer, film, region, plate, or the like can be disposed between the former and the latter. As used herein, when a layer, film, region, plate, or the like is directly disposed "below" or "under" another layer, film, region, plate, or the like, the former directly contacts the latter and still another layer, film, region, plate, or the like is not disposed between the former and the latter.

In descriptions of temporal relationships, for example, temporal precedent relationships between two events such as "after", "subsequent to", "before", etc., another event can occur therebetween unless "directly after", "directly subsequent" or "directly before" is not indicated.

It will be understood that, although the terms "first", "second", "third", and so on can be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

The features of the various examples of the present disclosure can be partially or entirely combined with each other, and can be technically associated with each other or operate with each other. The examples can be implemented independently of each other and can be implemented together in an association relationship.

As used herein, the term "substantially," "about," and similar terms are used as terms of approximation, and are intended to account for inherent deviations in measured or calculated values that would be recognized by those of ordinary skill in the art. The term can be used to prevent unauthorized exploitation by an unauthorized infringer to design around accurate or absolute figures provided to help understand the present disclosure.

Unless otherwise defined, all terms including technical and scientific terms used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

A display device of the present disclosure can be applied to an organic light-emitting display device, but may not be limited thereto, and can be applied to various display devices such as an LED display device or a quantum dot display device.

Hereinafter, various components of the display device that improve a heat-dissipation performance and an impact-absorbing function and improve a display quality while reducing a non-display area will be described.

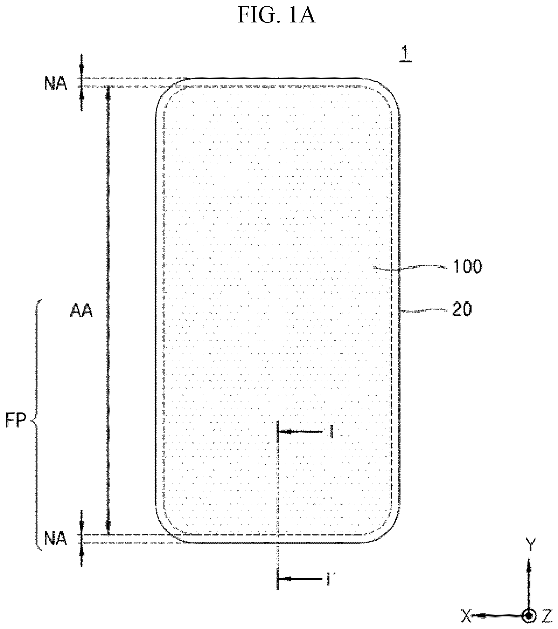

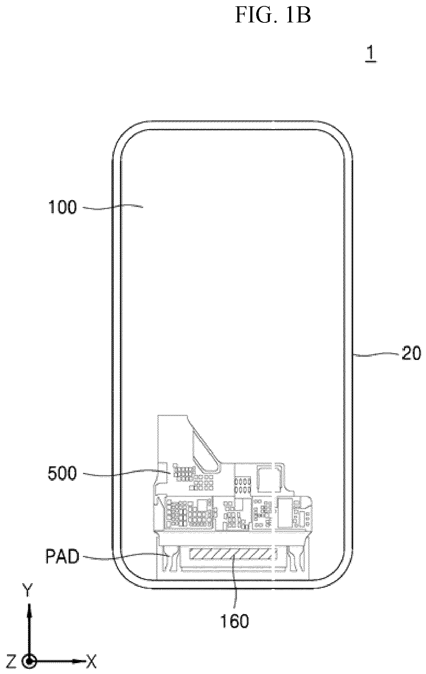

FIG. 1A shows a front surface of the display device where a display area is located, and FIG. 1B shows a back surface of the display device according to an embodiment of the present disclosure.

A direction of a front surface and an upward direction defined in the present disclosure refers to a Z-axis direction, and a direction of a back surface and a downward direction refer to a -Z-axis direction.

A display device 1 can include a cover member 20, a display panel 100 coupled to a back surface of the cover member 20, and a frame disposed on a back surface of the display panel 100 to support the cover member 20. The display panel 100 can be disposed between the cover member 20 and the frame.

The cover member 20 can be disposed to cover a front surface of the display panel 100 to protect the display panel 100 from an external impact.

An edge of the cover member 20 can be rounded to be curved in a direction of a back surface of the cover member 20 on which the display panel 100 is disposed.

In this case, the cover member 20 can be disposed to cover up to at least a portion of a side surface of the display panel 100, which is disposed on the back surface thereof, to protect not only the front surface but also the side surface of the display panel 100 from the external impact.

An image displayed on the display panel 100 can be displayed through a front surface of the cover member 20. Because the cover member 20 overlaps a display area AA for displaying the image, the cover member 20 can be made of a transparent material such as a cover glass such that the image can be displayed. For example, the cover member 20 can be made of a transparent plastic material, a glass material, or a reinforced glass material, but may not be limited thereto.

A front face portion FP of the cover member 20 can include the display area AA and a non-display area NA that is an area other than the display area AA. The non-display area NA can be formed along an edge of the display area AA, and the non-display area NA can be a bezel area.

The display panel 100 includes a bendable portion in which a portion of the display panel 100 is downwardly bendable, and a pad PAD extending from the bendable portion and disposed below a front face portion FP. A driving circuit 160 for driving a pixel can be mounted in the pad PAD, or a flexible circuit board 500 can be connected to the pad PAD. The flexible circuit board 500 can be electrically connected to the pad disposed at a distal end of the display panel 100 by a film attachment process mediated by a conductive adhesive layer 170, and can be located on the back surface of the display panel 100.

In this case, the conductive adhesive layer 170 can use an anisotropic conductive film such as an anisotropic conductive film (ACF).

In order to reduce the non-display area NA located at a lower end of the display panel 100, it is necessary to reduce a radius of curvature of the bendable portion.

The radius of curvature of the bendable portion is proportional to an overall thickness of the display panel 100. As the overall thickness increases, the radius of curvature of the bendable portion increases, resulting in an increase in the non-display area NA. As the overall thickness is reduced, the non-display area NA is reduced, resulting in the decrease in the radius of curvature of the bendable portion.

Therefore, in order to reduce the non-display area NA, it is necessary to reduce the thickness of the display panel 100.

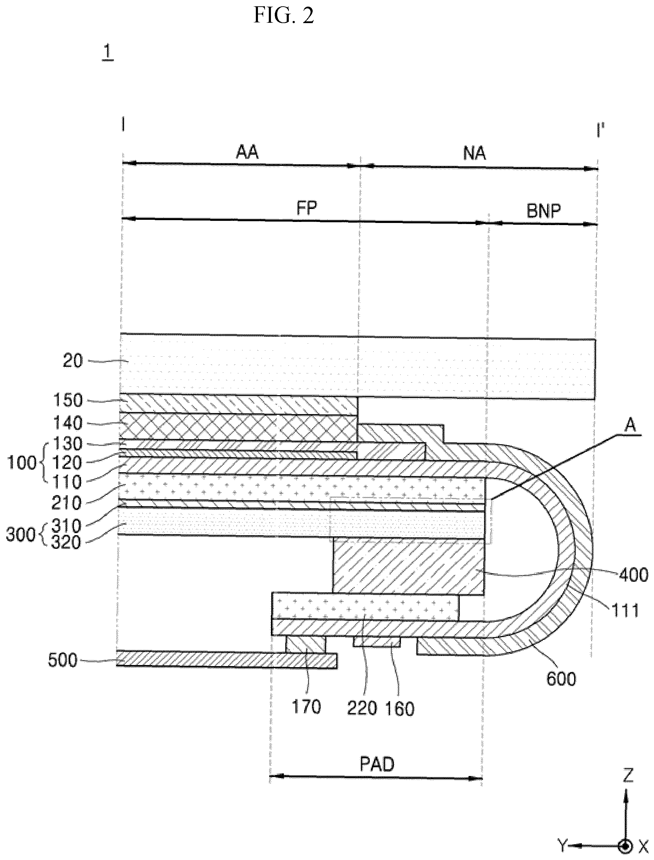

Hereinafter, with reference to FIG. 2, the display panel 100 and the cushion plate 300 according to an example of the present disclosure will be described in detail.

FIG. 2 is a cross-sectional view taken along a line I-I' in FIG. 1A according to an embodiment of the present disclosure.

Referring to FIG. 2, the display panel 100 can be connected or coupled to the back surface of the cover member 20.

The display panel 100 includes the front face portion FP, the bendable portion BNP, and the pad PAD bendable from the bendable portion BNP to be disposed on a back surface of the front face portion FP. The cushion plate 300 and a connecting member 400 are disposed between the front face portion FP and the pad PAD. The connecting member 400 can be disposed to fix the cushion plate 300 and the pad PAD.

For example, a first back plate 210, the cushion plate 300, the connecting member 400, a second back plate 220, and the pad PAD can be disposed at a lower portion of the front face portion FP of the display panel 100. For example, the first back plate 210, the cushion plate 300, the connecting member 400, the second back plate 220, and the pad PAD can be sequentially disposed at the lower portion of the front face portion FP of the display panel 100.

An adhesive layer 150 can be disposed on the back surface of the cover member 20, and the adhesive layer 150 can fix the display panel 100 to the cover member 20.

Because the adhesive layer 150 can be disposed to overlap the display area AA, the adhesive layer 150 can be made of a transparent adhesive member. For example, the adhesive layer 150 can be made of or contain a material such as an optical clear adhesive (OCA), an optical clear resin (OCR), or a pressure sensitive adhesive (PSA), but may not be limited thereto.

An optical film 140 can be further disposed between the adhesive layer 150 and the display panel 100. The optical film 140 can have a form in which one or more functional layers are stacked, but may not be limited thereto. For example, the optical film 140 can include an anti-reflection layer such as a polarizing film that can improve outdoor visibility and contrast of the image displayed on the display panel 100 by preventing reflection of external light.

Further, the optical film 140 can, for example, further include a barrier layer for preventing penetration of moisture or oxygen. The barrier layer can be made of a material having low moisture permeability, such as a polymer material.

The display panel 100 can include a display substrate 110, a pixel array 120 disposed on the display substrate 110, and an encapsulation portion 130 disposed to cover the pixel array 120. A touch electrode can be additionally disposed on the encapsulation portion 130.

The display substrate 110 can serve as a base of the display panel 100. The display substrate 110 can be made of a plastic material having flexibility to become the flexible display substrate 110.

For example, the display substrate 110 can contain polyimide, which is the plastic material having the flexibility, and can be made of a thin glass material having the flexibility.

The pixel array 120, which can correspond to an area displaying the image on the front surface of the cover member 20, can correspond to the display area AA.

Accordingly, in the cover member 20, an area corresponding to the pixel array 120 can be the display area AA, and an area other than the display area AA can be the non-display area NA.

The pixel array 120 can be implemented in a form of various elements that display the image, and may not be particularly limited.

The pixel array 120 can be disposed in a pixel area defined by signal lines on the display substrate 110, and can include a plurality of pixels that display the image based on a signal supplied to the signal lines. The signal lines can include a gate line, a data line, a pixel driving power line, and the like.

Each of the plurality of pixels can include, in a pixel area, a driving thin-film transistor, an anode electrode electrically connected to the driving thin-film transistor, a light-emitting element layer formed on the anode electrode, and a cathode electrode electrically connected to the light-emitting element layer.

The driving thin-film transistor can include a gate electrode, a semiconductor layer, a source electrode, and a drain electrode. The semiconductor layer of the thin-film transistor can contain silicon such as a-Si, poly-Si, or low-temperature poly-Si, or an oxide such as an indium-gallium-zinc-oxide (IGZO).

The anode electrode can be disposed to correspond to an opening area defined based on a shape of a pattern of the pixel in each pixel area to be electrically connected to the driving thin-film transistor.

The light-emitting element layer can contain, for example, an organic light-emitting element formed on the anode electrode. The organic light-emitting element can be implemented to emit light of the same color such as white light for each pixel or to emit light of a different color such as red, green, or blue for each pixel.

Alternatively, the light-emitting element layer can contain a micro light-emitting diode element electrically connected to each of the anode electrode and the cathode electrode. The micro light-emitting diode element, which is a light-emitting diode implemented in a form of an integrated circuit (IC) or a chip, can include a first terminal electrically connected to the anode electrode and a second terminal electrically connected to the cathode electrode.

The cathode electrode can be commonly connected to the light-emitting element of the light-emitting element layer in each pixel area.

The encapsulation portion 130 can be formed on the display substrate 110 to cover the pixel array 120. The encapsulation portion 130 can prevent the penetration of the oxygen, the moisture, or a foreign substance into the light-emitting element layer of the pixel array 120. For example, the encapsulation portion 130 can be formed in a multi-layer structure in which an organic material layer and an inorganic material layer are alternately stacked.

The display panel 100 is divided into the front face portion FP, the bendable portion BNP, and the pad PAD.

The front face portion FP of the display panel 100 is directed in a direction in which a screen is displayed, and the bendable portion BNP is a portion extending from the front face portion FP and bent in a downward direction. The pad PAD is a portion extending from the bendable portion BNP and is located on the back surface of the front face portion FP.

The first plate 210 can be disposed beneath the display substrate 110 to complement rigidity of the display substrate 110 and keep the portion of the display substrate 110 located in the front face portion FP in a flat state. The first plate 210 can be a back plate, but may not be limited by terms.

The first plate 210 may not be formed in a portion of the display panel 100 corresponding to the bendable portion BNP because the first plate 20 is formed to have certain strength and thickness to complement the rigidity of the display substrate 110.

The second plate 220 can be disposed on the pad PAD of the display panel 100 bent from the bendable portion BNP of the display panel 100 and disposed on the back surface of the front face portion FP. The second plate 220 can be the back plate, but may not be limited by terms.

Based on a shape of the display panel 100 before the bending, the second plate 220 can be disposed beneath the display substrate 110 to be spaced apart from the first plate 210. The second plate 220 can be disposed beneath the pad PAD of the display panel 100.

Moreover, based on a shape of the display panel 100 after the bending, the second plate 220 can be located on top of the pad PAD. The second plate 220 can be disposed between the front face portion FP and the pad PAD.

The second plate 220 can be disposed beneath the display substrate 110 to complement the rigidity of the display substrate 110 and keep the portion of the display substrate 110 located in the pad PAD in a flat state.

Because the first plate 210 and the second plate 220 are formed to have certain strengths and thicknesses to complement the rigidity of the display substrate 110, it is difficult to bend the display panel 100 in the areas where the first back plate 210 and the second back plate 220 are formed. Accordingly, because the first plate 210 and the second plate 220 are not formed in the portion of the display panel 100 corresponding to the bendable portion BNP, the display panel 100 can be easily bent.

The cushion plate 300 can be disposed beneath the first plate 210.

The cushion plate 300 includes an adhesive member 310 and a porous substrate 320. The porous substrate 320 can be a metal foam.

The adhesive member 310 is stacked to have a certain thickness on one surface of the porous substrate 320. Referring to FIG. 2, the porous substrate 320 is directed in the -Z-axis direction, which is a direction of a back surface of the adhesive member 310.

The adhesive member 310 can contain an adhesive component and can fix the porous substrate 320 to the first plate 210.

The connecting member 400 can be disposed between the cushion plate 300 and the second plate 220. The connecting member 400 can fix the bent display panel 100 such that the bent display panel 100 can maintain the bent shape. The connecting member 400 can be formed to have a certain thickness in a thickness direction to constantly maintain the curvature of the bendable portion BNP.

For example, the connecting member 400 can be a double-sided tape having an adhesive force that can fix the second plate 220 and the porous substrate 320, but may not be limited thereto. The connecting member 400 can be formed as a foam tape or a foam pad having the adhesive force to mitigate the impact.

The second plate 220 can be disposed beneath the connecting member 400. In order to fix the second plate 220 beneath the connecting member 400, the second plate 220 can be attached to a bottom surface of the pad PAD first, and then, the bendable portion BNP can be bent to attach and fix the second plate 220 to the bottom surface of the connecting member 400.

In the state in which the second plate 220 is fixed to the connecting member 400, an outer portion, which is a upper surface, of the bendable portion BNP can be exposed to the outside, and an inner portion, which is a bottom surface, of the bendable portion BNP can be disposed to side surfaces of the cushion plate 300 and the second connecting member 400.

In FIG. 2, the upper surface, which is the outer portion, of the bendable portion BNP can be an outer diameter portion 111, and a reinforcing member 600 can be disposed on the outer diameter portion 111. The reinforcing member 600 can cover the bendable portion BNP, and can extend to cover at least a portion of each of the front face portion FP and the pad PAD.

The reinforcing member 600 can contain a resin. For example, the reinforcing member 600 can contain an ultraviolet UV-curable acrylic resin, but may not be limited thereto.

The reinforcing member 600 can be made of a cured product of the resin that has undergone a curing process after being coated. When the ultraviolet-curable resin is used as the resin, it can be cured by UV curing. The reinforcing member 600 can be made of various materials, and may not be limited to the material described in the present disclosure.

Because the reinforcing member 600 can cover various signal lines disposed between the encapsulation portion 130 and the pad PAD of the display panel 100, it is possible to prevent the moisture from penetrating into the signal lines while protecting the signal lines from the external impact.

On the bendable portion BNP, in order to increase the flexibility of the display panel 100, some components except for the display substrate 110 and the signal lines can be omitted, and the reinforcing member 600 can supplement rigidity of the bendable portion BNP from which some components are omitted.

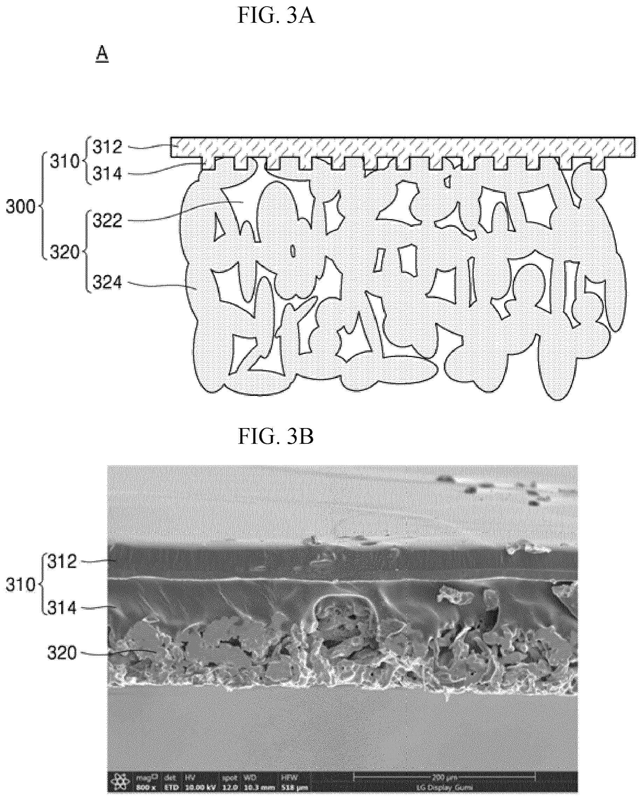

Hereinafter, with reference to FIG. 3A, the cushion plate 300 according to an example of the present disclosure will be described.

FIG. 3A is an enlarged cross-sectional view of an area A in FIG. 2, which is an example of a cushion plate according to the present disclosure.

Referring to FIG. 3A, the cushion plate 300 is composed of the porous substrate 320 and the adhesive member 310 for attaching the porous substrate 320 to the display panel 100 or the first plate 210.

The porous substrate 320 can be a porous metal structure containing a conductive metal 324 and a plurality of pores 322 disposed inside the conductive metal 324.

Because the conductive metal 324 of the porous substrate 320 is a metal with high thermal conductivity, the porous substrate 320 itself can provide an excellent heat-dissipation function. Because the porous substrate 320 has the form of the metal structure having the plurality of pores 322 therein, the porous substrate 320 can also provide an excellent cushion function.

Further, because the porous substrate 320 is made of the conductive metal 324 containing the plurality of pores 322 therein, an overall surface area thereof is increased, so that the porous substrate 320 itself can provide the excellent heat-dissipation function.

Therefore, the cushion plate 300 according to an example of the present disclosure can have the effective heat-dissipation function and cushion function at the same time with only the porous substrate 320 without a need to configure a heat-dissipation layer for the heat-dissipation function and a cushion layer for the cushion function as separate layers.

Further, because there is no addition of the component, a small thickness can be achieved to reduce the overall thickness, and thus, a width of the non-display area NA can be reduced.

A porosity of the porous substrate 320 having the plurality of pores 322 can be in a range from 50 % to 76 %, and a size of each pore can be in a range from 20 µm to 30 µm. When the porosity is lower than the above range, a weight of the porous substrate 320 increases, and the heat-dissipation effect decreases as the pores become dense. Conversely, when the porosity exceeds the above range, there is a problem in that it is difficult to maintain a desired rigidity.

The porous substrate 320 can be formed in, for example, a following manufacturing method, but may not be limited thereto.

The porous substrate 320 can be formed by sintering a metal foam precursor containing a metal powder.

The metal foam precursor refers to a structure before proceeding with a process, such as the sintering, performed to form the porous substrate 320.

For example, the metal foam precursor can be formed using a slurry containing a metal powder, a dispersant, and a binder.

The metal powder can be a metal powder in which one or more metal powders among a copper powder, a nickel powder, an iron powder, a SUS powder, a molybdenum powder, a silver powder, a platinum powder, a gold powder, an aluminum powder, a chromium powder, an indium powder, a tin powder, a magnesium powder, a phosphorus powder, a zinc powder, and a manganese powder are mixed, or a powder of an alloy of one or more metals, but may not be limited thereto.

The dispersant can, for example, use alcohol, but may not be limited thereto.

In this case, the alcohol can use monohydric alcohol having 1 to 20 carbon atoms, such as methanol, ethanol, propanol, pentanol, octanol, ethylene glycol, propylene glycol, pentanol, 2-methoxyethanol, 2-ethoxyethanol, 2-butoxyethanol, glycerol, texanol, or terpineol, dihydric alcohol having 1 to 20 carbon atoms, such as ethylene glycol, propylene glycol, hexanediol, octanediol, or pentanediol, or polyhydric alcohol, but may not be limited thereto.

A type of binder may not be particularly limited, and can be selected based on a type of the metal component or the dispersant used in preparing the slurry.

For example, the binder can use alkyl cellulose having an alkyl group having 1 to 8 carbon atoms, such as methyl cellulose or ethyl cellulose, polyalkylene carbonate having an alkylene unit having 1 to 8 carbon atoms, such as polypropylene carbonate or polyethylene carbonate, or a polyvinyl alcohol-based binder, such as polyvinyl alcohol or polyvinyl acetate, but may not be limited thereto.

After forming the slurry to contain the metal powder, the dispersant, and the binder as described above, the slurry can be injected into a mold having a predetermined shape or coated on a substrate to form the metal foam precursor.

The metal foam precursor thus formed can be formed into the porous substrate 320 through the sintering process.

In this case, conditions of the sintering process are not particularly limited as long as the sintering process is performed at a temperature and for a time of levels at which a solvent contained in the slurry can be removed to a desired level. For example, the sintering can be performed in a temperature range from about 50 °C to 250 °C for a predetermined time, but may not be limited thereto.

The cushion plate 300 can be formed by attaching the adhesive member 310 to one surface of the porous substrate 320 after forming the porous substrate 320.

Alternatively, the metal foam precursor can be formed on the adhesive member 310 and sintered to form the porous substrate 320 and the cushion plate 300. The method for manufacturing the cushion plate 300 is not particularly limited.

The adhesive member 310 can be in direct contact with the first back plate 210, and can be a layer for fixing the cushion plate 300 to the first back plate 210. The adhesive member 310 can contain an adhesive component and can function as an adhesive layer.

The adhesive member 310 can be made of or contain a material such as a pressure sensitive adhesive (PSA), an optical clear adhesive (OCA), or an optical clear resin (OCR). Among those, the pressure sensitive adhesive (PSA), which is a pressure sensitive adhesive, can be a viscoelastic adhesive that can be bonded even under a weakly applied pressure.

For example, the adhesive member 310 can be made of one material selected from a group consisting of acrylic, silicone, epoxy, and urethane-based materials having an adhesive component, but may not be limited thereto.

The adhesive member 310 is disposed on the porous substrate 320, and a upper surface of the adhesive member 310 has a flat shape. When the upper surface of the adhesive member 310 is formed flat, it is possible to prevent a surface of the porous substrate 320 from being visually recognized from the outside of the display panel 100, which is formed to be transparent to a certain level.

The surface of the porous substrate 320 has irregularities due to the plurality of pores 322. For example, the surface of the porous substrate is uneven shape, concavo-convex shape, embossed shape, or bumpy shape. The irregularities of the surface of the porous substrate 320 can be visually recognized from the outside through the display panel 100, which is transparent to the certain level. When the irregularities of the surface of the porous substrate 320 are visually recognized, the display quality of the display panel 100 can be lowered.

Further, when the adhesive is placed on the porous substrate 320, due to a low viscosity of the adhesive, the adhesive flows into the irregularities of the surface of the porous substrate 320, so that a surface of the adhesive can have irregularities along the surface of the porous substrate 320. The irregularities of the adhesive can be visually recognized from the outside through the display panel 100, which can deteriorate the display quality.

Therefore, it is necessary to improve the display quality by flattening the upper surface of the porous substrate 320 or the adhesive member 310 to prevent the irregularities of the surface of the porous substrate 320 or the adhesive member 310 from being visually recognized from the outside of the display panel 100.

The example in FIG. 3A is an example of the present disclosure for flattening the surface of the adhesive member 310, which is an example in which the surface of the adhesive member 310 is flattened by forming a plurality of fine protrusions 314 on the adhesive member 310.

The adhesive member 310 of the example of the present disclosure is composed of a flat portion 312 and the fine protrusions 314. An upper portion of the adhesive member 310 is formed as the flat portion 312 formed to be flat, and a portion beneath the flat portion is formed as the plurality of fine protrusions 314.

The plurality of fine protrusions 314 can be disposed at positions corresponding to the irregularities of the upper surface of the porous substrate 320, and the number thereof can be plural based on the number of irregularities. Because it can be difficult to make the fine protrusions 314 accurately correspond to the irregularities of the porous substrate 320, the fine protrusions 314 can be arranged based on an overall distribution of the irregularities.

For example, the surface of the porous substrate 320 can have the irregularities, and a size and a pitch of the plurality of fine protrusions 314 can correspond to those of the irregularities of the surface of the porous substrate 320. For example, each of the plurality of fine protrusions 314 can have a size in a range from 3 to 5 µm. When each of the plurality of fine protrusions 314 is formed in a circular shape, a diameter thereof can be in a range from 3 to 5 µm. When each of the plurality of fine protrusions 314 is formed in a rectangular shape, a length of one side can be in a range from 3 to 5 µm. Moreover, the pitch of the plurality of fine protrusions 314 can be in a range from 13 to 15 µm. For example, a distance from a center point of a specific fine protrusion 314 of the plurality of fine protrusions 314 to a center point of another neighboring fine protrusion 134 can be in a range from 13 to 15 µm.

The arrangement and the size of the plurality of fine protrusions 314 may not be limited thereto, and can change when a size, a shape, a pitch, and the like of the irregularities of the surface of the porous substrate 320 are changed.

That is, the larger the irregularities of the surface of the porous substrate 320, the larger the size and the pitch of the plurality of fine protrusions 314 can be, and the smaller the irregularities of the surface of the porous substrate 320, the smaller the size and the pitch of the plurality of fine protrusions 314 can be.

The plurality of fine protrusions can have the circular shape, a square shape, or the rectangular shape based on the irregularities of the surface of the porous substrate 320.

Because the irregularities of the porous substrate 320 have a certain level of surface roughness, the size, the shape, or the pitch of the plurality of fine protrusions can be changed based on the surface roughness of the porous substrate 320.

When the adhesive member 310 including the flat portion 312 and the plurality of fine protrusions 314 is attached to the porous substrate 320, the plurality of fine protrusions 314 are preferentially filled in the surface irregularities of the porous substrate 320, so that a surface of the upper surface of the flat portion 312 can maintain the flat shape without an occurrence of the irregularities.

Therefore, because the irregularities of the porous substrate 320 are not visually recognized from the outside of the display panel 100, the display quality of the display panel 100 can be improved.

In order to continuously maintain the flat shape of the adhesive member 310, the size of the fine protrusions 314 can be greater than that of the surface irregularities of the porous substrate 320.

When increasing the size of the fine protrusions 314, the fine protrusions 314 can be filled in the surface irregularities of the porous substrate 320, and excess fine protrusions 314 can be filled in the plurality of pores 322 disposed in an upper portion of the porous substrate 320. The fine protrusions 314 filled in the pores 322 of the porous substrate 320 function to support the fine protrusions 314 filled in the surface irregularities, so that the flat shape of the upper surface of the adhesive member 310 can be maintained for a long time. Further, the viscoelastic adhesive member 310 is filled in the plurality of pores 322 to also improve the impact-absorbing function of the cushion plate 300.

The adhesive member 310 including the fine protrusions 314 can be formed in variety of methods. For example, when the pressure sensitive adhesive (PSA) having the low viscosity is used as the adhesive member 310, the adhesive member 310 having the plurality of fine protrusions 314 can be formed by pressing a mold or a roller in which a plurality of fine concave patterns are defined while the PSA is cured to a certain level.

Alternatively, the adhesive member 310 having the plurality of fine protrusions 314 can be formed by applying the PSA onto the mold in which the plurality of fine concave patterns are defined, performing a treatment such as drying or curing on the mold to have certain viscosity and hardness, and removing the PSA from the mold.

Alternatively, the plurality of fine protrusions 314 can be formed by dropping PSA solution onto the flat portion 312 to have a certain size with a plurality of fine dispensers and curing the solution. The method for forming the adhesive member 310 including the fine protrusions 314 is not limited to the above-described method.

FIG. 3B is a product cross-sectional view in which an adhesive member with fine protrusions in FIG. 3A is attached to a porous substrate.

Referring to FIG. 3B, the fine protrusion 314 can be correspondingly filled in the irregularities of the porous substrate 320, so that the flat portion 312 located in the upper portion of the adhesive member 310 can maintain the flat shape.

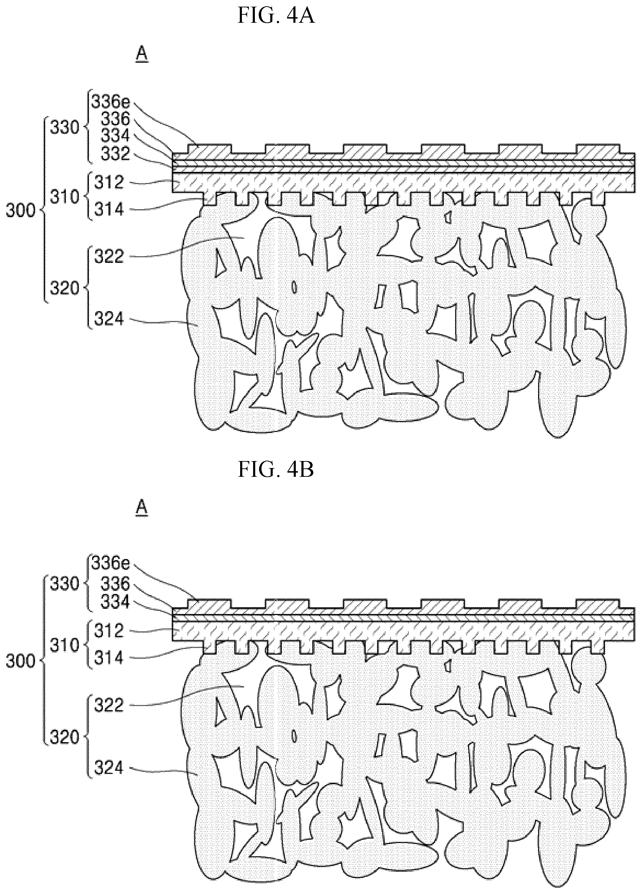

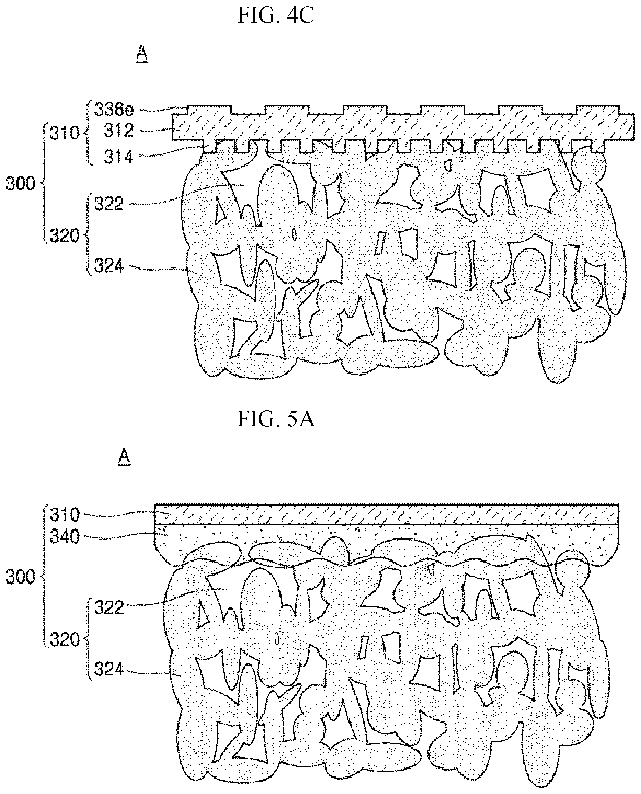

FIG. 4A to FIG. 4C are cross-sectional views of other examples of a cushion plate according to the present disclosure, which are examples in which an embossed layer is additionally placed in the structure described in FIG. 3A. The example shown in FIG. 4C is not according to the claimed invention.

Referring to FIG. 4A, the cushion plate 300 includes the porous substrate 320, the adhesive member 310, and the embossed layer 330.

The embossed layer 330, which is a kind of adhesive, can be disposed on a flat portion 312 of the porous substrate 320, and can include an embossed pattern 336e, which is an uneven structure formed on a upper surface thereof. When the cushion plate 300 is attached to the display panel 100 or the first back plate 210, the embossed pattern 336e, which is the uneven structure of the embossed layer 330, can prevent air bubbles from being generated between the cushion plate 300 and the display panel 100 or the first back plate 210. A defoaming process for removing the air bubbles can be omitted by adding the embossed layer 330.

The embossed layer 330 can contain the adhesive component, and can be in direct contact with the display panel 100 or the first back plate 210 to fix the porous substrate 320 to the display panel 100 or the first back plate 210.

The embossed layer 330 can include a base 334, and a first layer 332 and a second layer 336 respectively disposed on both surfaces or both sides of the base 334.

The second layer 336 of the embossed layer 330 can have the plurality of embossed patterns 336e like the uneven structure. The embossed patterns 336e can have a shape similar to that of the fine protrusions 314 of the adhesive member 310, but can have larger size and pitch than the fine protrusions 314 to remove the air bubbles. Because the shape and the pitch of each of the fine protrusion 314 and the embossed pattern 336e can be changed depending on a product, the shape and the pitch thereof are not limited by a specific shape or numerical value.

At least one of the first layer 332, the second layer 336, and the embossed pattern 336e can be made of a material having the adhesive component. For example, all of the first layer 332, the second layer 336, and the embossed pattern 336e can be made of the material having the adhesive component.

The base 334 can serve to maintain the shape of the embossed layer 330, and can be made of a material having certain strength and hardness to maintain a shape thereof. For example, the base 334 can be made of a material such as polyethylene terephthalate (PET), but may not be limited thereto.

FIG. 4B is an example of a structure in which the first layer 332 of the embossed layer 330 is removed from the structure described in FIG. 4A.

Because the adhesive member 310 disposed beneath the embossed layer 330 also contains the adhesive component, even when the first layer 332 of the embossed layer 330 is removed, the embossed layer 330 can be attached to and fixed on the adhesive member 310.

Therefore, the embossed layer 330 can be composed of the base 334 and the second layer 336 having the embossed pattern 336e, and the base 334 of the embossed layer 330 can be attached to and fixed on the adhesive member 310.

FIG. 4C is another example of the present disclosure, which is not according to the claimed invention and which is an example of a structure in which the embossed pattern is integrally formed on the adhesive member 310 in the structure described in FIG. 4A.

The example of the present disclosure can form the additional embossed pattern 336e on the upper surface of the adhesive member 310 without adding the embossed layer 330 to replace the embossed layer 330.

For example, the fine protrusions 314 can be formed on the bottom surface of the flat portion 312 of the adhesive member 310 and the embossed pattern 336e can be formed on the upper surface of the flat portion 312.

FIG. 5A is a cross-sectional view showing another example of a cushion plate, which is not according to the claimed invention.

Referring to FIG. 5A, the cushion plate 300 can include the porous substrate 320, a planarization film 340, and the adhesive member 310. The planarization film 340 can be disposed between the porous substrate 320 and the adhesive member 310.

The planarization film 340 is located on the upper surface of the porous substrate 320 and serves to flatten the upper surface of the cushion plate 300. The planarization film 340 can also be filled in the plurality of pores 322 disposed in the upper portion of the porous substrate 320, thereby increasing a bonding force between the planarization film 340 and the porous substrate 320.

The planarization film 340 can be formed by curing an organic film such as a low-viscosity resin, and various materials and manufacturing methods can be used for the planarization film 340.

For example, the planarization film 340 can use a material combined with photo acryl, polyimide, or carbon, silicon, oxygen, and the like, but may not be limited thereto.

The adhesive member 310 for the adhesion of the first back plate 210 or the display panel 100 can be disposed on top of the planarization film 340. Because the upper surface of the porous substrate 320 can be flattened by the planarization film 340, the fine protrusion for the planarization can be omitted on the adhesive member 310 disposed on top of the planarization film 340.

The adhesive member 310 is disposed on top of the planarization film 340 and is formed flat by the planarization film 340, so that the irregularities of the upper surface of the porous substrate 320 is not visually recognized from the outside of the display panel 100.

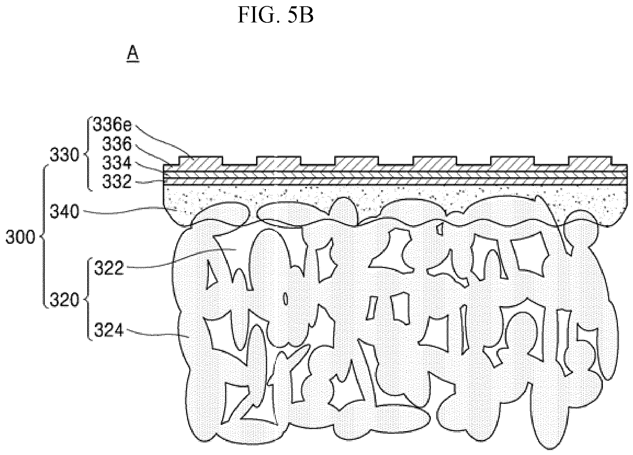

FIG. 5B is a cross-sectional view showing another example of a cushion plate, which is not according to the claimed invention.

FIG. 5B is a view showing the cushion plate 300 in which the planarization film 340 is disposed on top of the porous substrate 320 and the embossed layer 330 is disposed on top of the planarization film 340 in the same manner as in FIG. 5A.

The embossed layer 330 can be disposed to attach the cushion plate 300 to the display panel 100 or the first back plate 210 without the air bubbles. The embossed layer 330 can include the base 334, and the first layer 332 and the second layer 336 having the embossed pattern 336e respectively disposed on the both surfaces or the both sides of the base 334.

When sequentially stacking the planarization film 340 and the embossed layer 330 on top of the porous substrate 320, because it is possible to prevent the irregularities of the porous substrate 320 from being visually recognized and to remove the air bubbles generated when the cushion plate 300 is attached, the display quality of the display device can be further improved.

As another example of the present disclosure, which is not according to the claimed invention, when the planarization film 340 is made of a material having adhesiveness, because the planarization film 340 can be directly attached to the display panel 100 or the first back plate 210, the additional adhesive member or the embossed layer may not be additionally disposed.

Therefore, when the planarization film 340 is made of the adhesive material, a manufacturing process of the display device can be simplified and a manufacturing cost can be reduced.

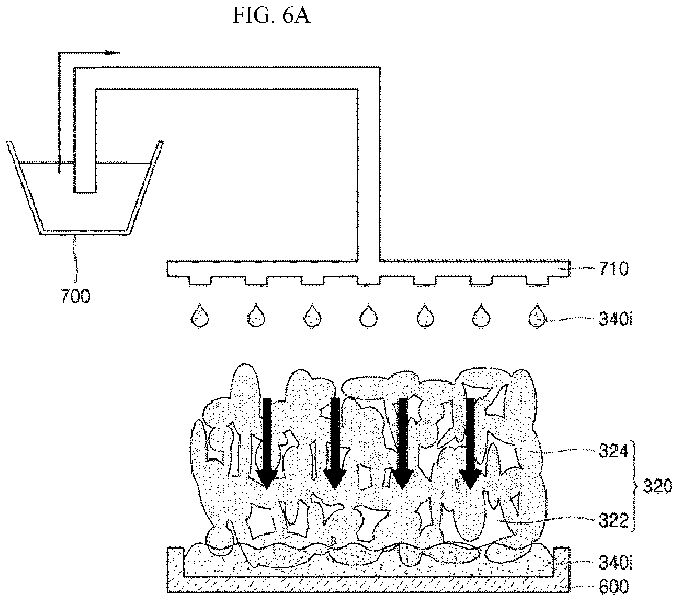

FIG. 6A to FGI. 6C are diagrams for a method for manufacturing a cushion plate including a planarization film, which is not according to the claimed invention.

Referring to FIG. 6A, in order to form the planarization film 340, the porous substrate 320 containing the conductive metal 324 and the plurality of pores 322 are disposed in a container 600. The porous substrate 320 can be disposed inside the container upside down, and can be disposed at a certain distance from a bottom of the container 600.

A low-viscosity resin 340i is injected into the porous substrate 320 placed in the container 600. As an injection method of the low-viscosity resin 340i, for example, a method of transferring the low-viscosity resin 340i filled in a water tank 700 to a nozzle 710 via a transfer pipe and uniformly discharging the low-viscosity resin 340i downward via the nozzle 710 to uniformly apply or inject the low-viscosity resin 340i from a location above the porous substrate 320 can be used. The low-viscosity resin 340i can be injected using various injection methods, and the present disclosure may not be limited thereto.

The applied or injected low-viscosity resin 340i at the location above the porous substrate 320 flows downward through the plurality of pores 322 defined in the porous substrate 320, and is filled in a lower portion of the porous substrate 320.

When the porous substrate 320 is spaced apart from the container 600 by the certain distance, the low-viscosity resin 340i is formed on a bottom surface of the porous substrate 320 to have a certain thickness. A portion of the low-viscosity resin 340i in contact with the container 600 can be flat. The low-viscosity resin 340i can also be filled in the plurality of pores 322 located in the lower portion of the porous substrate 320, thereby increasing a bonding force between the planarization film 340 and the porous substrate 320 to be described later.

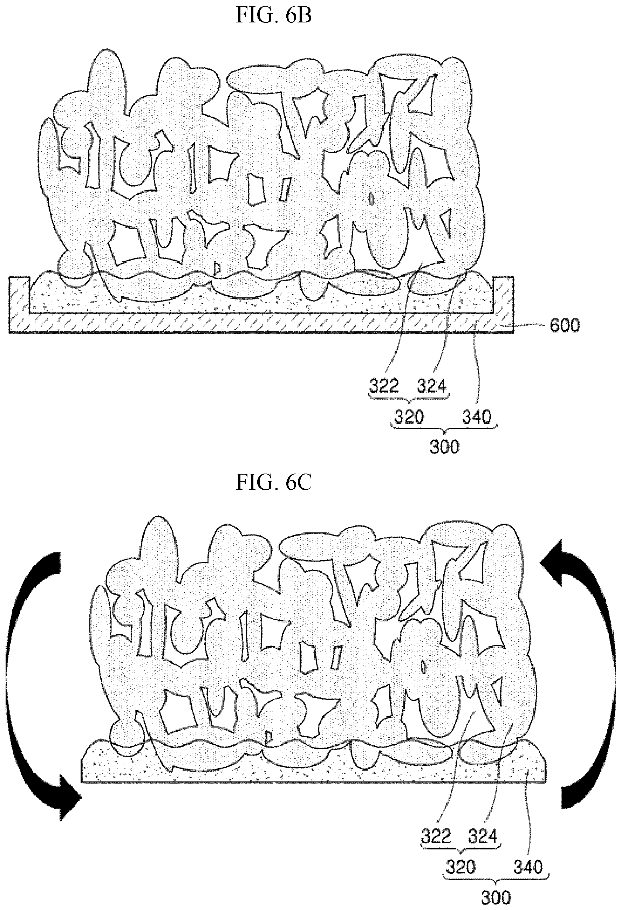

Referring to FIG. 6B, the low-viscosity resin 340i filled in the lower portion of the porous substrate 320 is cured by applying heat or an ultraviolet ray to form the planarization film 340. A method for curing the low-viscosity resin 340i can be various depending on a material of the low-viscosity resin 340i. When curing the low-viscosity resin 340i by applying the heat, a container 600 of a metal component having good heat transfer characteristics can be used. When curing the low-viscosity resin 340i by applying the ultraviolet ray, a container 600 of a transparent material can be used.

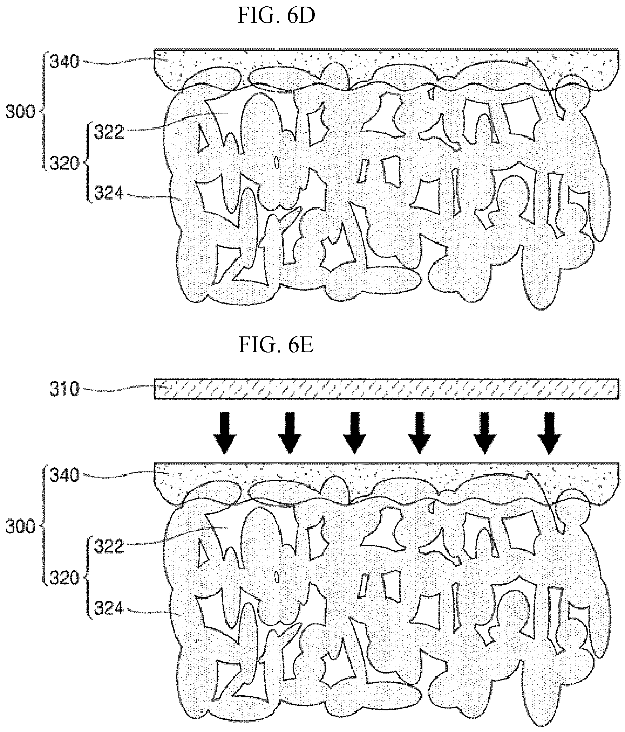

Referring to FIG. 6C and FIG. 6D, which also refer to a method that is not according to the claimed invention, the porous substrate 320 on which the planarization film 340 is formed is removed from the container 600 by curing the low-viscosity resin 340i, and the porous substrate 320 on which the planarization film 340 is formed is turned over such that the planarization film 340 goes to the top.

Referring to FIG. 6E, which also refers to a method that is not according to the claimed invention, the adhesive member 310 can be attached onto the porous substrate 320 on which the planarization film 340 is formed. Because the top of the planarization film 340 is flat by the container 600, the adhesive member 310 can have the flat shape without a need to form the fine protrusions. In order to prevent the air bubbles generated during the adhesion, the embossed pattern can be further formed on the upper surface of the adhesive member 310.

Alternatively, the embossed layer having the embossed pattern can be attached on top of the porous substrate 320 on which the planarization film 340 is formed. The embossed layer can be formed as the layer having the embossed pattern and the adhesive component, and may not be limited to a specific structure.

When the planarization film 340 is made of the adhesive material, there is no need to additionally dispose the adhesive member or the embossed layer, so that the structure of the cushion plate 300 can be simplified.

The display device according to an example of the present disclosure can be described as follows.

A first aspect of the present disclosure provides a display device, as defined in appended claim 1, including: a display panel including a front face portion that is an area where an image is displayed, a bendable portion extending from the front face portion, and a pad extending from the bendable portion and disposed below the front face portion; and a cushion plate disposed between the front face portion and the pad. The cushion plate includes a porous substrate and an adhesive member disposed on the porous substrate, and a upper surface of the adhesive member has a flat shape.

The adhesive member further includes a flat portion and a plurality of fine protrusions disposed on a bottom surface of the flat portion, and the plurality of fine protrusions are in contact with a upper surface of the porous substrate.

In one implementation of the first aspect, the upper surface of the porous substrate has irregularities, and the plurality of fine protrusions are disposed to correspond to the irregularities of the porous substrate.

In one implementation of the first aspect, the irregularities of the porous substrate have a certain level of surface roughness, and a size and a pitch of the plurality of fine protrusions can correspond to the surface roughness of the porous substrate.

In one implementation of the first aspect, a size of the plurality of fine protrusions is in a range from 3 to 5 µm, and a pitch of the plurality of fine protrusions is in a range from 13 to 15 µm.

In one implementation of the first aspect, the plurality of fine protrusions have a circular shape, a square shape, or a rectangular shape.

In one implementation of the first aspect, the porous substrate contains a conductive metal and a plurality of pores located inside the conductive metal.

In one implementation of the first aspect, the adhesive member is further disposed within a plurality of pores disposed in an upper portion of the porous substrate.

In one implementation of the first aspect, the display device further includes an embossed layer disposed on top of the adhesive member.

A scope of protection of the present disclosure should be construed by the scope of the claims, and all technical ideas within the scope equivalent thereto should be construed as being included in the scope of the present disclosure. Although the examples of the present disclosure have been described in more detail with reference to the accompanying drawings, the present disclosure is not necessarily limited to these examples. The present disclosure can be implemented in various modified manners within the scope not departing from the technical idea of the present disclosure. Accordingly, the examples disclosed in the present disclosure are not intended to limit the technical idea of the present disclosure, but to describe the present disclosure. the scope of the technical idea of the present disclosure is not limited by the examples. Therefore, it should be understood that the examples as described above are illustrative and non-limiting in all respects. The scope of protection of the present disclosure is defined by the claims.

## Claims

1. A display device comprising:
a display panel including a front face portion that is an area where an image is displayed, a bendable portion extending from the front face portion, and a pad extending from the bendable portion and disposed below the front face portion; and
a cushion plate (300) disposed between the front face portion and the pad,
wherein the cushion plate includes a porous substrate (320) and an adhesive member (310) disposed on the porous substrate, wherein an upper surface of the adhesive member has a flat shape;
wherein an upper portion of the adhesive member is formed as a flat portion and a portion beneath the flat portion is formed as a plurality of fine protrusions (314),
wherein the plurality of fine protrusions are in contact with an upper surface of the porous substrate.

2. The display device of claim 1, wherein the upper surface of the porous substrate has irregularities, and the plurality of fine protrusions are disposed to correspond to the irregularities of the porous substrate.

3. The display device of claim 1, wherein a size of the plurality of fine protrusions is in a range from 3 to 5 µm, and a pitch of the plurality of fine protrusions is in a range from 13 to 15 µm.

4. The display device of claim 1 or claim 3, wherein the plurality of fine protrusions have a circular shape, a square shape, or a rectangular shape.

5. The display device of any one of the preceding claims, wherein the porous substrate contains a conductive metal and a plurality of pores located inside the conductive metal.

6. The display device of any one of the preceding claims, further comprising an embossed layer disposed on top of the adhesive member.

## Patentansprüche

1. Anzeigevorrichtung, umfassend:
ein Anzeigefeld, das beinhaltet: einen Vorderseitenabschnitt, der ein Bereich ist, wo ein Bild angezeigt wird; einen biegbaren Abschnitt, der sich von dem Vorderseitenabschnitt ausgehend erstreckt; und ein Pad, das sich von dem biegbaren Abschnitt ausgehend erstreckt und unter dem Vorderseitenabschnitt angebracht ist; und
eine Polsterplatte (300), die zwischen dem Vorderseitenabschnitt und dem Pad angebracht ist,
wobei die Polsterplatte ein poröses Substrat (320) und ein Haftelement (310) beinhaltet, die auf dem porösen Substrat angebracht ist, wobei eine Oberseite des Haftelements eine flache Form aufweist;
wobei ein oberer Abschnitt des Haftelements als ein flacher Abschnitt gebildet ist und wobei ein Abschnitt unter dem flachen Abschnitt als eine Vielzahl von feinen Vorsprüngen (314) gebildet ist,
wobei die Vielzahl von feinen Vorsprüngen in einem Kontakt mit einer Oberseite des porösen Substrats stehen.

2. Anzeigevorrichtung nach Anspruch 1, wobei die Oberseite des porösen Substrats Unregelmäßigkeiten aufweist und wobei die Vielzahl von feinen Vorsprüngen angebracht sind, um den Unregelmäßigkeiten des porösen Substrats zu entsprechen.

3. Anzeigevorrichtung nach Anspruch 1, wobei eine Größe der Vielzahl von feinen Vorsprüngen in einem Bereich von 3 bis 5 µm liegt, und wobei eine Schrittweite der Vielzahl von feinen Vorsprüngen in einem Bereich von 13 bis 15 µm liegt.

4. Anzeigevorrichtung nach Anspruch 1 oder Anspruch 3, wobei die Vielzahl von feinen Vorsprüngen eine kreisförmige Gestalt, eine quadratische Gestalt oder eine rechteckige Gestalt aufweisen.

5. Anzeigevorrichtung nach einem der vorhergehenden Ansprüche, wobei das poröse Substrat ein leitfähiges Material und eine Vielzahl von Poren enthält, die sich innerhalb des leitfähigen Metalls befinden.

6. Anzeigevorrichtung nach einem der vorhergehenden Ansprüche, die ferner eine geprägte Schicht umfasst, die oben auf dem Haftelement angebracht ist.

## Revendications

1. Dispositif d'affichage comprenant :
un panneau d'affichage comportant une partie de face avant qui est une zone où une image est affichée, une partie pliable s'étendant depuis la partie de face avant, et un clavier s'étendant depuis la partie pliable et disposé sous la partie de face avant ; et
une plaque d'amortissement (300) disposée entre la partie de face avant et le clavier,
dans lequel la plaque d'amortissement comporte un substrat poreux (320) et un élément adhésif (310) disposé sur le substrat poreux, une surface supérieure de l'élément adhésif ayant une forme plate,
dans lequel une partie supérieure de l'élément adhésif se présente sous la forme d'une partie plate et une partie située sous la partie plate se présente sous la forme d'une pluralité de fines saillies (314),
dans lequel la pluralité de fines saillies sont en contact avec une surface supérieure du substrat poreux.

2. Dispositif d'affichage de la revendication 1, dans lequel la surface supérieure du substrat poreux présente des irrégularités, et la pluralité de fines saillies sont disposées pour correspondre aux irrégularités du substrat poreux.

3. Dispositif d'affichage de la revendication 1, dans lequel une taille de la pluralité de fines saillies se situe dans une plage de 3 à 5 µm, et un pas de la pluralité de fines saillies se situe dans une plage de 13 à 15 µm.

4. Dispositif d'affichage de la revendication 1 ou la revendication 3, dans lequel la pluralité de fines saillies ont une forme circulaire, une forme carrée, ou une forme rectangulaire.

5. Dispositif d'affichage de l'une quelconque des revendications précédentes, dans lequel le substrat poreux contient un métal conducteur et une pluralité de pores situés à l'intérieur du métal conducteur.

6. Dispositif d'affichage de l'une quelconque des revendications précédentes, comprenant en outre une couche gaufrée disposée au-dessus de l'élément adhésif.
